(19)

Europäisches
Patentamt
European
Patent Office
Office européen
des brevets

(11)　EP 2 850 030 B1

(12)　　EUROPEAN PATENT SPECIFICATION

(45) Date of publication and mention
of the grant of the patent:
**10.08.2016　Bulletin 2016/32**

(21) Application number: **13722999.3**

(22) Date of filing: **15.05.2013**

(51) Int Cl.:
***B81C 1/00*** *(2006.01)*　　***B82Y 40/00*** *(2011.01)*
***C09D 7/00*** *(2006.01)*　　***B82Y 30/00*** *(2011.01)*

(86) International application number:
**PCT/EP2013/001440**

(87) International publication number:
**WO 2013/170959 (21.11.2013 Gazette 2013/47)**

(54) **METHOD FOR PRODUCING HIGHLY ORDERED ARRAYS OF MICELLES OR NANOPARTICLES ON A SUBSTRATE SURFACE**

VERFAHREN ZUR HERSTELLUNG VON ARRAYS HOHER ORDNUNG AUS MIZELLEN ODER NANOPARTIKELN AUF EINER SUBSTRATOBERFLÄCHE

PROCÉDÉ DE FABRICATION D'ENSEMBLES EXTRÊMEMENT ORDONNÉS DE MICELLES OU DE NANOPARTICULES SUR UNE SURFACE DE SUBSTRAT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.05.2012　PCT/EP2012/002090**

(43) Date of publication of application:
**25.03.2015　Bulletin 2015/13**

(73) Proprietors:
- **Max-Planck-Gesellschaft zur Förderung der Wissenschaften e.V.
80539 München (DE)**
- **Ernst-Abbe-Hochschule Jena
07745 Jena (DE)**

(72) Inventors:
- **WILLIGES, Christian
12051 Berlin (DE)**
- **MORHARD, Christoph
71640 Ludwigsburg (DE)**
- **SPATZ, Joachim, P.
70569 Stuttgart (DE)**
- **BRUNNER, Robert
07743 Jena (DE)**

(74) Representative: **v. Bezold & Partner Patentanwälte - PartG mbB
Akademiestraße 7
80799 München (DE)**

(56) References cited:
**EP-A1- 2 260 995**　　　**DE-A1-102009 060 223**
**US-A1- 2010 112 234**

- **ROMAN GLASS ET AL: "Block copolymer micelle nanolithography on non-conductive substrates; Block copolymer micelle nanolithography on non-conductive substrates", NEW JOURNAL OF PHYSICS, INSTITUTE OF PHYSICS PUBLISHING, BRISTOL, GB, vol. 6, no. 1, 6 August 2004 (2004-08-06), pages 101-101, XP020080459, ISSN: 1367-2630, DOI: 10.1088/1367-2630/6/1/101**
- **TEREKHIN V V ET AL: "Diblock copolymer micellar lithography: 2. Formation of highly ordered nanoparticle ensembles with controlled geometric characteristics", COLLOID JOURNAL, KLUWER ACADEMIC PUBLISHERS-PLENUM PUBLISHERS, NE, vol. 73, no. 5, 2 October 2011 (2011-10-02), pages 707-716, XP019959990, ISSN: 1608-3067, DOI: 10.1134/S1061933X11050164**
- **XIAOJIANG ZHANG ET AL: "Fast Assembly of Ordered Block Copolymer Nanostructures through Microwave Annealing", ACS NANO, vol. 4, no. 11, 23 November 2010 (2010-11-23), pages 7021-7029, XP055049895, ISSN: 1936-0851, DOI: 10.1021/nn102387c**

**Description**

Background

In recent years substrate surfaces with periodic or quasiperiodic nanostructures have found widespread use in a broad range of different applications, e.g. in the fields of optics, electronics, spectroscopy, sensor technology, lithography etc.

Especially advantageous methods for generating such nanostructures involve the use of self-assembling techniques such as block copolymer micellar nanolithography (BCML) and similar methods. In comparison with "classic" lithographic processes, self-assembling techniques are relatively simple, inexpensive, very fast and are principally suitable to provide even rather extended or 3-dimensional surfaces with the desired nanostructures.

However, in contrast to conventional lithographic methods such self-assembling techniques are more prone to the generation of structural defects. It is possible to minimize the presence of such defects by selecting suitable process conditions but it is difficult to avoid such inherent defects completely. Moreover, the interparticle distances of such structures tend to vary to a certain extent. Both structural defects and variations of the interparticle distance are very undesirable for many applications. This limits the use of self-assembling techniques for structuring surfaces in spite of the above advantages.

It is known to heal structural defects of 3-dimensional crystals by thermal annealing processes. In the course of such annealing processes, the thermal energy applied to the crystalline system results in the generation of an excited state of the system which can be re-structured and re-ordered rather easily, leading to the elimination of structural defects. The corresponding increase of the crystal lattice order obtained by these processes is largely maintained when the crystalline system returns into the ground state. Attempts have been made to improve the degree of order of self-assembled nanostructures on a substrate surface by annealing processes as well. For this purpose, processes based on either vapour annealing (Yoo et al., J. Mater. Chem. 2007, 17, 2969-2975) or solvent annealing (Cavicchi et al., Polymer, 46, 2005, 11635-11639) were developed. The method of vapour annealing involves exposing the nanostructured substrate for several hours to an atmosphere of a specific solvent, such as THF. This method is slow and requires a rather sophisticated equipment and the use of toxic solvents. In the method of solvent annealing a thin solvent film is applied onto the substrate and subsequently evaporated in a controlled manner in a suitable atmosphere such as nitrogen. This method is only applicable for some polymers and is also quite laborious due to the required controlled evaporation. Moreover, both methods are often not suitable to achieve a very high degree of order of the nanostructures.

Thus, an object of the present invention is to provide an improved method for producing highly ordered arrays of micelles or nanoparticles on a substrate which is fast, cost-efficient and simple to perform without the need of expensive equipment.

The method according to the present invention provides large and very highly ordered arrays of micelles or nanoparticles on a substrate surface.

The method according to the present invention involves an annealing step by ultrasonication in a polar liquid medium according to claim 1. Further aspects and preferred embodiments of the invention are the subject of additional claims.

Description of the invention

The method for increasing the order of an array of polymeric micelles or of nanoparticles on a substrate surface according to claim 1 comprises at least the following steps

   a) providing an ordered array of micelles or nanoparticles coated with a polymer shell on a substrate surface and
   b) annealing the array of micelles or nanoparticles by ultrasonication in a liquid medium which comprises or consists of a $C_1$-$C_{10}$ alkanol, in particular methanol, ethanol, propanol and butanol, or a mixture of $H_2O$ and $C_1$-$C_{10}$ alkanol, in particular methanol, ethanol, propanol and butanol,

wherein the ultrasonication is effected at a temperature in the range from 15°C to 70°C, preferably in the range of 20°C to 25°C, and at a frequency in the range of 20 kHz to 2 MHz, preferably 30 kHz to 2 MHz, and a power input in the range of 5W/l to 50 W/l, preferably 15 W/l to 30 W/l.

In a more specific embodiment, the method according to the present invention comprises the following steps

   a) providing an ordered array of polymeric micelles loaded with at least one metal salt on a substrate surface,
   b) annealing the array of micelles or nanoparticles by ultrasonication in a liquid medium which comprises or consists of a C1-C10 alkanol, in particular methanol, ethanol, propanol and butanol, or a mixture of $H_2O$ and C1-C10 alkanol, and
   c) converting the at least one metal salt in said micelles by an oxidation or reduction treatment into inorganic nanoparticles and optionally partial or complete removal of the organic copolymer of the micelles by a plasma treatment.

The substrate surface to be coated may be any substrate capable to be coated with the polymeric micelles or nanoparticles coated with a polymer shell. Some non-limiting examples are glasses, Si, $SiO_2$, ZnO, $TiO_2$,

$Al_2O_3$, C, InP, GaAs, GaP, GaInP, AlGaAs.

In a preferred embodiment of the method of the invention, the ordered array of micelles is a hexagonal array produced by a block copolymer micellar nanolithography (BCML) technique.

In the micellar nanolithography (see, e.g., EP 1 027 157) a micellar solution of a diblock-or multiblock copolymer is deposited onto a substrate, e.g., by immersion coating, and, given suitable conditions on the surface, forms an ordered film structure of chemically different polymer domains, depending, i.a., on the type, molecular weight and concentration of the block copolymer. For example, the distances of the individual polymer domains from each other are a function of the molecular weight and the concentration of the block polymer in the solution. The micelles in the solution can be charged with inorganic salts or acids that can be reduced to inorganic nanoparticles after the deposition with the polymer film.

Basically any micelle-forming block copolymer can be used as two-block or multi-block copolymer in this method that can be deposited as a film onto a substrate and that forms an ordered structure of different polymer domains. Suitable block copolymers are, for example, all block copolymers mentioned in the above-cited EP 1 027 157. In a more specific embodiment, the two-block- or multi-block copolymer is selected from the group of polystyrene (n)-b-poly (2-vinylpyridine (m), polystyrene (n)-b-poly (4-vinylpyridine (m), polystyrene (n)-b-poly (ethylene oxide) (m), in which n and m indicate the number of repetition units and are, independently of one another, integers in the range of 10-10,000, in particular 100-1000. The molecular weight (Mw) (dissolved block) is preferably selected >> Mw (poorly dissolved block).

Basically all inorganic metal compounds (e.g., metallic salts) that can be converted by oxidation or reduction into inorganic nanoparticles are suitable as inorganic compounds with which the micelles in the solution and the polymer domains in the deposited plastic film, respectively, can be charged. Suitable salts are, for example, all metallic salts mentioned in the above-cited EP 1 027 157. The metallic salts used in accordance with the invention preferably comprise at least one salt of the metals Au, Pt, Pd, Ag, In, Fe, Zr, Al, Co, Ni, Ga, Sn, Zn, Ti, Si or Ge. $HAuCl_4$ is especially preferred.

The nanoparticles coated with a polymer shell are preferably selected from the group comprising metals, such as Au, Ag, Pd, Pt, Cu, Ni and mixtures thereof, metal oxides such as $Al_2O_3$, $Fe_2O_3$, $Cu_2O$, $TiO_2$, $SiO_2$, Si or other semiconductors.

The polymer shell may comprise any polymer suitable for the desired purpose. Some specific, non-limiting examples are polymers selected from the group comprising polystyrene, polypyridine, polyolefines including polydienes, PMMA and other poly(meth)acrylates, and blends or copolymers thereof.

In a preferred embodiment, the shell-forming polymer has a terminal anchoring group with a high affinity to the surface of the nanoparticles. The term "anchoring group having a high affinity to the surface of the nanoparticles", as used herein, includes anchoring groups capable to form a covalent bond (or a bond with a strong covalent character) with molecules of the nanoparticles or functional groups thereon. Typically, the functional anchoring group is a thiol, amine, COOH, ester or phosphine group.

The annealing of nanostructures on a substrate surface according to the present invention is effected by means of ultrasonication in a liquid medium, which comprises or consists of a $C_1$-$C_{10}$ alkanol, in particular methanol, ethanol, propanol and butanol, or a mixture of $H_2O$ and a $C_1$-$C_{10}$ alkanol, in particular methanol, ethanol, propanol and butanol.

In a more preferred embodiment, the solvent consists of ethanol or of a mixture of $H_2O$ and ethanol in a ratio in the range from 2:1 to 0.01:1, preferably in a ratio of about 1:2.

The ultrasonication is effected at a frequency in the range of 20 kHz - 2 MHz, preferably from 30 kHz to 1 or 2 MHz or from 1 MHz to 2 MHz, and a power input in the range of 5 W/l to 50 W/l, preferably from 15 W/l to 30 W/l.

Contrary to annealing methods of the prior art, excellent results are obtained in a rather short time. Typically, the ultrasonication is effected for a time period in the range of from 10 to 500 s, preferably 30-200 s, such as 50-150 s.

The ultrasonication is effected over a broad temperature range from 15°C to 70°C, more specifically 18-50°C or 18°C-40°C, but it is convenient and usually sufficient to use a temperature near room temperature, such as a temperature in the range from 20°C to 30°C, preferably from 20°C to 25°C.

In the method according to the present invention, said ultrasonication treatment typically results in at least 10 % increase of the order of the array of micelles or nanoparticles as indicated by a corresponding decrease of the standard deviation of the mean intermicelle or interparticle distance. If the array of micelles or nanoparticles initially provided has an especially low degree of order, the increase of order achieved by the method of the invention may be even higher.

It should be recognized that the method of the invention may also be applied advantageously to eliminate local structural defects of an extended array of micelles or nanoparticles which exhibits an overall relatively high degree of order.

Thus, even if the overall order of the array of micelles or nanoparticles is not increased considerably by the method of the invention, the elimination of local defects may still represent an essential improvement of the nanostructured substrate in order to qualify for a number of applications.

In a specific embodiment of the invention, the array of micelles or nanoparticles is provided in the interspaces of larger primary structures. Typically, these primary structures have mean distances in the range from to 25 nm to 10 µm, preferably in the range from 25 nm to 500 nm, 30 nm to 500 nm, or 50 nm to 500 nm, and are produced by "classical" lithographic methods such as optical, UV, or deep-UV (mask-based) lithography, direct-writing techniques, electron-beam lithography or nano-Imprint techniques. These prestructered substrates can be used in the method of the invention as outlined above.

The method according to the present invention provides very highly ordered arrays of micelles or nanoparticles .

Typically, such ordered arrays of micelles or nanoparticles, in particular inorganic nanoparticles, on a substrate surface have a mean distance of micelles or particles in the range from 5 nm to 250 nm, preferably 5-100 nm or 25-250 nm, and a standard deviation of the mean value of less than 10 %, preferably less than 5 %, such as 1-3 %.

If the ordered arrays of micelles or nanoparticles are provided in the interspaces of larger primary structures, the mean distance of said micelles or particles will be markedly smaller than the mean distance of the respective primary structures, typically in the range from 10-50 nm, 5-50 nm, 5-25 nm, 5-20 nm or 5-10 nm.

The highly ordered arrays of micelles or nanoparticles obtained by the method of the present invention are of interest for a wide variety of applications, in particular in the fields of optics, electronics, spectroscopy, sensor technology, imaging technology, biochips, data storing and processing, lithography.

Thus, a further aspect not being part of the invention relates to a device, in particular an optic device, spectroscopic device or sensor device, a mask, in particular a lithographic mask or photo mask, a biochip, a tool for a replication process, a transistor, an integrated circuit, a processor, or a memory-device, comprising said highly ordered arrays.

These highly ordered arrays are used for manufacturing a device which is selected from the group comprising a mask, in particular a lithographic mask or photo mask, a biochip, a tool for a replication process, a sensor, an optical device or a transistor, an integrated circuit, a processor, or a memory-device.

Brief Description of the Figures

Fig. 1 shows SEM micrographs of a substrate surface structured with gold nanoparticles (in order to show the order more clearly the individual particles have been masked with white circles): (A) before annealing; B) after annealing

Fig. 2 shows the results of an ultrasound annealing treatment of a micellar array with varying solvent ratios: (A) Increase of the degree of order of the micellar array; (B) Decrease of the standard deviation of the mean distance of the micellar array

Fig. 3 shows the results of an ultrasound annealing treatment of a micellar array with varying solvent ratios and subsequent plasma treatment to obtain a corresponding gold nanoparticle array; (A) Increase of the degree of order of the nanoparticle array ; (B) Decrease of the standard deviation of the mean distance of the nanoparticle array

Fig. 4 shows the results of an ultrasound annealing treatment of a micellar array with a solvent ratio ethanol:$H_2O$ = 2:1 and varying duration of the annealing treatment: (A) Increase of the degree of order of the micellar array; (B) Decrease of the standard deviation of the mean distance of the micellar array

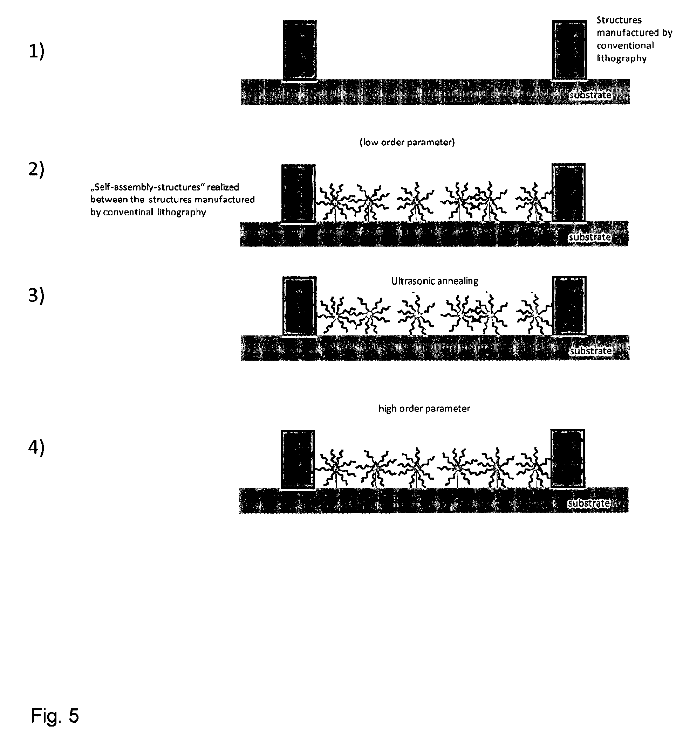

Fig. 5 shows schematically a specific embodiment of the invention, wherein the array of micelles or nanoparticles is provided in the interspaces of larger primary structures.

The present invention is illustrated in more detail in the following non-limiting examples.

EXAMPLE 1

*Preparation of highly ordered arrays of micelles on a substrate surface*

Arrays of gold-salt loaded micelles on a glass substrate were prepared by micellar block copolymer nanolithography essentially according to published methods (e.g. EP 1 027 157).

As an initial step, a 5 mg/ml toluene solution of micelles of the diblock copolymer polystyrene-block-polyvinylpyridine (PS-b-P2VP; Mn(PS) 190.000; Mn (P2VP) 55.000; Mw/Mn = 1.10) loaded with $HAuCl_4$ was prepared and stored in a sealed glass vial.

This micellar solution was applied on a glass substrate (24 mm x 24 mm) by spin coating (6000 rpm, 1 min) in a spin coater (WS-400B, Laurell Technologies, North Wales, USA) and left drying.

The conditions were adjusted so that a sample with a mean micelle distance of 68-72 nm and a standard deviation of the mean distance value in range of 9-13 nm was obtained. If desired, it is possible to decrease the initial degree of order by adding ultra pure $H_2O$ to the above polymer solution (e.g. 1 vol. %).

The resulting nanostructured sample was placed in a commercial sonifier (Sanorex, Bandelion electronic, Berlin) and immersed in a liquid medium consisting of a mixture of ethanol:$H_2O$ in different ratios at room temperature and sonicated at a frequency of 35 kHz and a power input in the range of 5-50 W/l, preferably 15-30 W/l, for 120 s.

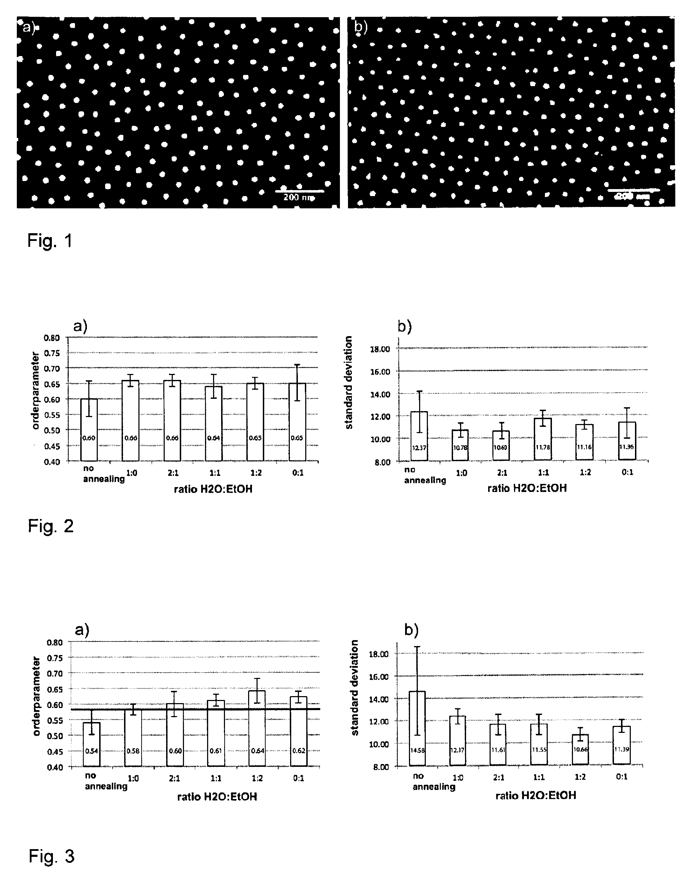

Fig. 2 shows the results of this ultrasound annealing treatment with different solvent ratios. These diagrams were obtained by image processing of corresponding SEM micrographs. The data are derived from 14 measuring points (7 different positions on 2 identically treated samples).

The degree of order as used herein is indicated by the "sixfold bond-orientational order parameter" $\psi_6$ as defined by D. Nelson and B. I. Halperin in Physical Review B 19.5 (1979), 2457-2484, for a hexagonal array.

$$\psi_6 = \left| \frac{1}{N_{bonds}} \sum_j \sum_k e^{i \cdot 6 \cdot \theta_{jk}} \right|$$

with $N_{bonds}$ = number of connections between the central particle of a hexagon and its next neighbors; $\theta_{jk}$ = angle between a central particle and 2 next neighbors in juxtaposition, k = central particle and j = neighbor.

For an ideal structure exclusively consisting of perfect hexagons, the order parameter $\psi_6 = 1$.

A high order parameter corresponds to a low standard deviation of the interparticle distance, both values are largely inverse proportional to each other. Thus, for a more simple indication of the order of a nanostructured array, often the standard deviation of the interparticle or intermicelle distance is used herein.

As evident from Fig. 2, a marked increase of the degree of order of the micellar array and a corresponding decrease of the standard deviation of the mean distance of the micellar array is observed in each case. The influence of the specific solvent ratio is rather low.

In order to assess the influence of the duration of the annealing treatment, a micellar array was prepared as indicated above and ultrasonicated for different time periods with an ethanol: $H_2O$ ratio of 2:1.

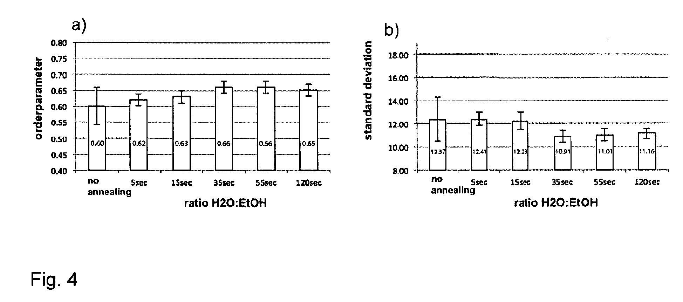

Fig. 4 shows that a rather short annealing time of about 35-55 s already provides excellent results with respect to the increased degree of order of the micellar array and a corresponding decrease of the standard deviation of the mean distance of the micellar array. Considerable longer annealing times resulted in rather marginal improvements.

EXAMPLE 2

*Preparation of highly ordered arrays of nanoparticles on a substrate surface*

A micellar array was prepared on a glass substrate and subjected to an ultrasound annealing treatment with varying solvent ratios analogous to Example 1.

The resulting micellar array was subjected to a plasma treatment essentially according to published methods (e.g. EP 1 027 157). Typically, the substrate was treated with W10 plasma (90 vol.% argon and 10 vol.% hydrogen) at a pressure of 0.4 mbar for 45 minutes and 150 W power input in a PlasmaSystem 100 (PVA TePla, Wettenberg, Germany) device.

In the course of this process, the polymer shell of said micelles was removed and the gold salt contained therein was reduced to elemental gold, whereby a highly ordered array of gold nanoparticles was obtained.

Fig. 3 shows the results of the preceding ultrasound annealing treatment with different solvent ratios. These diagrams were obtained by image processing of corresponding SEM micrographs. The data are derived from 14 measuring points (7 different positions on 2 identically treated samples).

The plasma treatment results in a slightly lower degree of order as compared with the initial micellar array and a corresponding increase of the standard deviation of the mean interparticle distance to about 14.5 nm for the non-annealed sample.

A considerable increase of the degree of order of the nanoparticle array and a corresponding decrease of the standard deviation of the mean distance of the nanoparticle array was observed for each solvent ratio. In this case, however, a strong influence of the specific solvent ratio is evident. Best results were obtained with an ethanol:$H_2O$ ratio of 2:1.

**Claims**

1. A method for increasing the order of an array of polymeric micelles or of nanoparticles on a substrate surface comprising

   a) providing an ordered array of micelles or nanoparticles coated with a polymer shell on a substrate surface and
   b) annealing the array of micelles or nanoparticles by ultrasonication in a liquid medium which comprises or consists of a $C_1$-$C_{10}$ alkanol, in particular methanol, ethanol, propanol and butanol, or a mixture of $H_2O$ and a $C_1$-$C_{10}$ alkanol, in particular methanol, ethanol, propanol and butanol,

   wherein the ultrasonication is effected at a temperature in the range from 15°C to 70°C, preferably in the range of 20°C to 25°C, and at a frequency in the range of 20 kHz to 2 MHz, preferably 30 kHz to 2 MHz, and a power input in the range of 5 W/l to 50 W/l, preferably 15 W/l to 30 W/l.

2. The method according to claim 1, wherein the solvent consists of ethanol or of a mixture of $H_2O$ and ethanol in a ratio in the range from 2:1 to 0.01:1, preferably in a ratio of about 1:2.

3. The method according to claim 1 or 2, wherein the ultrasonication is effected for a time period in the range of 10 to 500 s, preferably 30 to 200 s, such as 50 to 150 s.

4. The method according to any one of claims 1-3, wherein the ordered array of micelles is a hexagonal array produced by a block copolymer micellar nanolithography (BCML) technique.

**5.** The method according to any one of claims 1-4, wherein the substrate is selected from the group comprising glasses, Si, $SiO_2$, ZnO, $TiO_2$, $Al_2O_3$, C, InP, GaAs, GaP, GaInP, AlGaAs.

**6.** The method according to any one of claims 1-5, wherein the micelles are micelles of a two-block- or multi-block copolymer selected from the group of polystyrene (n)-b-poly (2-vinylpyridine (m), polystyrene (n)-b-poly (4-vinylpyridine (m), polystyrene (n)-b-poly (ethylene oxide) (m), in which n and m indicate the number of repetition units and are, independently of one another, integers in the range of 10-10,000, in particular 100-1000.

**7.** The method according to any one of claims 1-6, wherein the nanoparticles coated with a polymer shell are selected from the group comprising metals, such as Au, Ag, Pd, Pt, Cu, Ni and mixtures thereof, metal oxides such as $Al_2O_3$, $Fe_2O_3$, $Cu_2O$, $TiO_2$, $SiO_2$, Si or other semiconductors.

**8.** The method according to any one of claims 1-7, wherein the micelles are loaded with at least one metal salt.

**9.** The method according to claim 9, wherein the least one metal salt is selected from the group comprising salts of Au, Ag, Pd, Pt, In, Fe, Zr, Al, Co, Ni, Ga, Sn, Zn, Ti, Si and Ge.

**10.** The method according to claim 8 or 9 comprising the following steps:

a) providing an ordered array of polymeric micelles loaded with at least one metal salt on a substrate surface,
b) annealing the array of micelles by ultrasonication in a liquid medium which comprises or consists of a $C_1$-$C_{10}$ alkanol, in particular methanol, ethanol, propanol and butanol, or a mixture of $H_2O$ and a $C_1$-$C_{10}$ alkanol, and
c) converting the at least one metal salt in said micelles by an oxidation or reduction treatment into inorganic nanoparticles and optionally partial or complete removal of the organic copolymer of the micelles by a plasma treatment.

**11.** The method according to any one of claims 1-10, wherein the ultrasonication treatment results in at least 10 % increase of the order of the array of micelles or nanoparticles as indicated by a corresponding decrease of the standard deviation of the mean intermicelle or interparticle distance.

**12.** The method according to any one of claims 1-11, wherein the substrate surface is prestructured with primary structures having mean distances in the range from to 25 nm to 10 $\mu$m, preferably in the range from 25 nm to 500 nm, and the ordered array of micelles or inorganic nanoparticles is provided in the interspace between these structures.

**13.** The method according to claim 12, wherein the primary structures having mean distances in the range from to 25 nm to 10 $\mu$m, preferably in the range from 25 nm to 500 nm, are formed on the substrate surface by lithographic techniques such as optical, UV, or deep-UV lithography, direct-writing techniques (laser-lithography), electron-beam lithography or nano-Imprint techniques.

**Patentansprüche**

**1.** Verfahren zur Erhöhung des Ordnungsgrades einer Anordnung von polymeren Mizellen oder von Nanopartikeln auf einer Substratoberfläche, welches umfasst

a) Bereitstellen einer geordneten Anordnung von Mizellen oder Nanopartikeln, die mit einer Polymerhülle beschichtet sind, auf einer Substratoberfläche und
b) Tempern der Anordnung von Mizellen oder Nanopartikeln durch Ultrabeschallung in einem flüssigen Medium, welches einen $C_1$-$C_{10}$-Alkanol, insbesondere Methanol, Ethanol, Propanol und Butanol, oder eine Mischung von $H_2O$ und einem $C_1$-$C_{10}$-Alkanol, insbesondere Methanol, Ethanol, Propanol und Butanol, umfasst oder daraus besteht, wobei die Ultrabeschallung bei einer Temperatur im Bereich von 15°C bis 70°C, vorzugsweise im Bereich von 20°C bis 25°C, und bei einer Frequenz im Bereich von 20 kHz bis 2 MHz, vorzugsweise 30 kHz bis 2 MHz, und einer Energiezufuhr im Bereich von 5 W/l bis 50 W/l, vorzugsweise 15 W/l bis 30 W/l, durchgeführt wird.

**2.** Verfahren nach Anspruch 1, wobei das Lösungsmittel aus Ethanol oder aus einer Mischung von $H_2O$ und Ethanol in einem Verhältnis im Bereich von 2:1 bis 0,01:1, vorzugsweise in einem Verhältnis von etwa 1:2, besteht.

**3.** Verfahren nach Anspruch 1 oder 2, wobei die Ultrabeschallung für eine Zeitspanne im Bereich von 10 bis 500 s, vorzugsweise 30 bis 200 s, z.B. 50 bis 150 s, durchgeführt wird.

**4.** Verfahren nach irgendeinem der Ansprüche 1-3, wobei es sich bei der geordneten Anordnung von Mizellen um eine hexagonale Anordnung, welche durch eine Technik der mizellaren Blockcopolymer-Nanolithografie (BCML) hergestellt wurde, handelt.

5. Verfahren nach irgendeinem der Ansprüche 1-4, wobei das Substrat aus der Gruppe ausgewählt ist, die Gläser, Si, SiO$_2$, ZnO, TiO$_2$, Al$_2$O$_3$, C, InP, GaAs, GaP, GaInP, AlGaAs umfasst.

6. Verfahren nach irgendeinem der Ansprüche 1-5, wobei die Mizellen Mizellen eines Zweiblock- oder Multiblock-Copolymers sind, das aus der Gruppe von Polystyrol(n)-b-poly(2-vinylpyridin)(m), Polystyrol(n)-b-poly(4-vinylpyridin)(m), Polystyrol(n)-b-poly(ethylenoxid)(m) ausgewählt sind, wobei n und m die Anzahl der Wiederholungseinheiten angeben und unabhängig voneinander ganze Zahlen im Bereich von 10-10.000, insbesondere 100-1000, darstellen.

7. Verfahren nach irgendeinem der Ansprüche 1-6, wobei die mit einer Polymerhülle beschichteten Nanopartikel aus der Gruppe ausgewählt sind, die Metalle, z.B. Au, Ag, Pd, Pt, Cu, Ni und Mischungen davon, Metalloxide, z.B. Al$_2$O$_3$, Fe$_2$O$_3$, Cu$_2$O, TiO$_2$, SiO$_2$, Si oder andere Halbleiter umfasst.

8. Verfahren nach irgendeinem der Ansprüche 1-7, wobei die Mizellen mit mindestens einem Metallsalz beladen sind.

9. Verfahren nach Anspruch 9, wobei das mindestens eine Metallsalz aus der Gruppe ausgewählt ist, welche Salze von Au, Ag, Pd, Pt, In, Fe, Zr, Al, Co, Ni, Ga, Sn, Zn, Ti, Si und Ge umfasst.

10. Verfahren nach Anspruch 8 oder 9, welches die folgenden Schritte umfasst:

a) Bereitstellen einer geordneten Anordnung von polymeren Mizellen, die mit mindestens einem Metallsalz beladen sind, auf einer Substratoberfläche,
b) Tempern der Anordnung von Mizellen durch Ultrabeschallung in einem flüssigen Medium, welches einen C$_1$-C$_{10}$-Alkanol, insbesondere Methanol, Ethanol, Propanol und Butanol, oder eine Mischung von H$_2$O und einem C$_1$-C$_{10}$-Alkanol umfasst oder daraus besteht, und
c) Überführen des mindestens einen Metallsalzes in den Mizellen durch eine Oxidations- oder Reduktionsbehandlung in anorganische Nanopartikel und gegebenenfalls partielles oder vollständiges Entfernen des organischen Copolymers der Mizellen durch eine Plasmabehandlung.

11. Verfahren nach irgendeinem der Ansprüche 1-10, wobei die Ultraschallbehandlung zu einer mindestens 10 %-igen Erhöhung des Ordnungsgrades der Anordnung von Mizellen oder Nanopartikeln, wie durch eine entsprechende Verringerung der Standardabweichung des mittleren Intermizellen- oder Interpartikelabstandes angezeigt, führt.

12. Verfahren nach irgendeinem der Ansprüche 1-11, wobei die Substratoberfläche mit Primärstrukturen, die mittlere Abstände im Bereich von 25 nm bis 10 $\mu$m, vorzugsweise im Bereich von 25 nm bis 500 nm, aufweisen, vorstrukturiert ist und die geordnete Anordnung von Mizellen oder anorganischen Nanopartikeln im Zwischenraum zwischen diesen Strukturen bereitgestellt wird.

13. Verfahren nach Anspruch 12, wobei die Primärstrukturen, welche mittlere Abstände im Bereich von 25 nm bis 10 $\mu$m, vorzugsweise im Bereich von 25 nm bis 500 nm, aufweisen, auf der Substratoberfläche durch lithografische Techniken, z.B. optische Lithografie, UV- oder Tief-UV-Lithografie, Direktabbildungstechniken (Laser-Lithografie), Elektronenstrahl-Lithografie oder Nano-Imprint-Techniken gebildet werden.

## Revendications

1. Procédé d'augmentation de l'ordre d'un réseau de micelles polymères ou de nanoparticules sur une surface de substrat comprenant

a) la fourniture d'un réseau ordonné de micelles ou de nanoparticules revêtues d'une enveloppe polymère sur une surface de substrat et
b) le recuit du réseau de micelles ou de nanoparticules par ultrasonication dans un milieu liquide qui comprend ou est constitué d'un alcanol en C1-C10, en particulier le méthanol, l'éthanol, le propanol et le butanol, ou d'un mélange d'H$_2$O et d'un alcanol en C1-C10, en particulier le méthanol, l'éthanol, le propanol et le butanol,

dans lequel l'ultrasonication est réalisée à une température dans la plage de 15°C à 70°C, de préférence dans la plage de 20°C à 25°C, et à une fréquence dans la plage de 20 KHz à 2 MHz, de préférence de 30 kHz à 2 MHz, et à une puissance d'entrée dans la plage de 5 W/l à 50 W/l, de préférence de 15 W/l à 30 W/l.

2. Procédé selon la revendication 1, dans lequel le solvant est constitué d'éthanol ou d'un mélange d'H$_2$O et d'éthanol en un rapport dans la plage de 2/1 à 0,01/1, de préférence en un rapport d'environ 1/2.

3. Procédé selon la revendication 1 ou 2, dans lequel l'ultrasonication est réalisée pendant une durée dans la plage de 10 à 500 s, de préférence de 30 à 200 s, par exemple de 50 à 150 s.

**4.** Procédé selon l'une quelconque des revendications 1 à 3, dans lequel le réseau ordonné de micelles est un réseau hexagonal produit par une technique de nanolithographie micellaire à base de copolymères séquencés (BCML).

**5.** Procédé selon l'une quelconque des revendications 1 à 4, dans lequel le substrat est sélectionné dans le groupe comprenant les verres, le Si, le SiO$_2$, le ZnO, le TiO$_2$, l'Al$_2$O$_3$, le C, l'InP, le GaAs, le GaP, le GaInP, l'AlGaAs.

**6.** Procédé selon l'une quelconque des revendications 1 à 5, dans lequel les micelles sont des micelles d'un copolymère biséquencé ou multiséquencé sélectionné dans le groupe du polystyrène (n)-b-poly (2-vinylpyridine) (m), du polystyrène (n)-b-poly (4-vinylpyridine) (m), du polystyrène (n)-b-poly (oxyde d'éthylène) (m), dans lesquels n et m indiquent le nombre d'unités répétées et sont, indépendamment l'un de l'autre, des nombres entiers dans la plage de 10 à 10 000, en particulier de 100 à 1 000.

**7.** Procédé selon l'une quelconque des revendications 1 à 6, dans lequel les nanoparticules revêtues d'une enveloppe polymère sont sélectionnées dans le groupe comprenant des métaux, tels qu'Au, Ag, Pd, Pt, Cu, Ni et des mélanges de ceux-ci, des oxydes de métaux tels qu'Al$_2$O$_3$, Fe$_2$O$_3$, CU$_2$O, TiO$_2$, SiO$_2$, Si ou d'autres semi-conducteurs.

**8.** Procédé selon l'une quelconque des revendications 1 à 7, dans lequel les micelles sont chargées d'au moins un sel de métal.

**9.** Procédé selon la revendication 9, dans lequel le ou les sels de métaux sont sélectionnés dans le groupe comprenant les sels d'Au, d'Ag, de Pd, de Pt, d'In, de Fe, de Zr, d'Al, de Co, de Ni, de Ga, de Sn, de Zn, de Ti, de Si et de Ge.

**10.** Procédé selon la revendication 8 ou 9, comprenant les étapes suivantes :

a) fourniture d'un réseau ordonné de micelles polymères chargées d'au moins un sel de métal sur une surface de substrat,
b) recuit du réseau de micelles par ultrasonication dans un milieu liquide qui comprend ou est constitué d'un alcanol en C1-C10, en particulier le méthanol, l'éthanol, le propanol et le butanol, ou d'un mélange d'H$_2$O et d'un alcanol en C1-C10, et
c) la conversion du ou des sels de métaux dans lesdites micelles par un traitement d'oxydation ou de réduction en nanoparticules inorganiques et facultativement le retrait partiel ou total du copolymère organique des micelles par un traitement par plasma.

**11.** Procédé selon l'une quelconque des revendications 1 à 10, dans lequel le traitement d'ultrasonication résulte en une augmentation d'au moins 10 % de l'ordre du réseau de micelles ou de nanoparticules tel qu'indiqué par une réduction correspondante de l'écart type de la distance inter-micellaire ou inter-particulaire moyenne.

**12.** Procédé selon l'une quelconque des revendications 1 à 11, dans lequel la surface de substrat est pré-structurée avec des structures primaires ayant des distances moyennes dans la plage de 25 nm à 10 μm, de préférence dans la plage de 25 nm à 500 nm, et le réseau ordonné de micelles ou de nanoparticules inorganiques est fourni dans l'espace entre ces structures.

**13.** Procédé selon la revendication 12, dans lequel les structures primaires ayant des distances moyennes dans la plage de 25 nm à 10 μm, de préférence dans la plage de 25 nm à 500 nm, sont formées sur la surface de substrat par des techniques lithographiques telles que des techniques de lithographie optique, UV ou UV profond, des techniques d'écriture directe (lithographie laser), des techniques de nano-impression ou de lithographie par faisceau d'élec-trons.

Fig. 1

Fig. 2

Fig. 3

Fig. 4

1)

Structures
manufactured by
conventional
lithography

substrate

(low order parameter)

2)

"Self-assembly-structures" realized
between the structures manufactured
by conventinal lithography

substrate

3)

Ultrasonic annealing

substrate

high order parameter

4)

substrate

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1027157 A

**Non-patent literature cited in the description**

- **YOO et al.** *J. Mater. Chem.,* 2007, vol. 17, 2969-2975
- **CAVICCHI et al.** *Polymer,* 2005, vol. 46, 11635-11639
- **D. NELSON ; B. I. HALPERIN.** *Physical Review B,* 1979, vol. 19 (5), 2457-2484